# FASCICULE DE BREVET EUROPEEN

(11) **EP 4 559 018 B1**
(45) Date de publication et mention de la délivrance du brevet: **17.06.2026**
(21) Numéro de dépôt: 23749129.5
(22) Date de dépôt: 18.07.2023
(51) Int. Cl.: H10P 90/00, H10N 30/079, H10N 30/00, H10W 10/10, H10P 14/60

(54) **PROCÉDÉ DE FABRICATION D'UN SUBSTRAT SUPPORT POUR APPLICATION RADIOFRÉQUENCES**
VERFAHREN ZUR HERSTELLUNG EINES TRÄGERSUBSTRATS FÜR EINE HOCHFREQUENZANWENDUNG
METHOD FOR MANUFACTURING A SUPPORT SUBSTRATE FOR A RADIOFREQUENCY APPLICATION

(30) Priorité: 19.07.2022 FR 2207362; 05.10.2022 FR 2210185
(43) Date de publication de la demande: 28.05.2025
(73) Titulaire: SOITEC, 38190 Bernin (FR)
(72) Inventeur: KIM, Young-Pil, 38190 BERNIN (FR); WONG, Chee-Hoe, 38190 BERNIN (FR)
(74) Mandataire: Regimbeau
(86) Numéro de dépôt international: PCT/FR2023/051108
(87) Numéro de publication internationale: WO 2024/018149

(56) Documents cités:
- JP-A- 2015 228 432
- US-A1- 2017 040 210
- US-A1- 2020 020 520

## Description

### DOMAINE DE L'INVENTION

La présente invention concerne un procédé de préparation d'un substrat support pour la réalisation d'une structure de type semi-conducteur sur isolant ou piézoélectrique sur isolant, ledit substrat support comprenant une couche d'oxyde et une couche de piégeage de charges. L'invention se rapporte également à un tel substrat support.

Ces substrats support trouvent une application notable dans le domaine des dispositifs intégrés radiofréquences, c'est-à-dire des dispositifs électroniques traitant des signaux dont la fréquence est comprise entre environ 3kHz et 300GHz, par exemple dans le domaine des télécommunications (téléphonie, Wi-Fi, Bluetooth...).

### ETAT DE LA TECHNIQUE

Un substrat du type semiconducteur sur isolant (SOI, acronyme du terme anglo-saxon « Silicon On Insulator »), respectivement piézoélectrique sur isolant (POl, acronyme du terme anglo-saxon « Piezoelectric On Insulator ») tel qu'utilisé pour des applications radiofréquences comprend successivement un substrat support, une couche d'oxyde enterré (souvent désignée par l'acronyme BOX, pour « Buried OXide ») et une couche semiconductrice, respectivement piézoélectrique, monocristalline, qui est la couche active, c'est-à-dire dans ou sur laquelle sont destinés à être formés des composants électroniques.

Afin d'éviter ou de limiter le phénomène de couplage électromagnétique qui peut se produire entre un dispositif électronique et le substrat support d'un substrat de silicium sur isolant sur lequel ledit dispositif est formé, il est connu d'intégrer au substrat support une couche de polysilicium (silicium polycristallin) directement sous la couche d'oxyde enterrée. Les joints dans les grains qui forment le polycristal constituent des pièges pour les porteurs de charge. Ainsi, on empêche la formation d'un plan conducteur sous l'isolation.

Avant la formation de la couche de piégeage, il est connu de former une couche de passivation sur le substrat support. Une telle couche favorise la formation de la couche de piégeage et empêche sa recristallisation, notamment pendant des montées en température du substrat. La couche de passivation est en un diélectrique amorphe, typiquement en dioxyde de silicium.

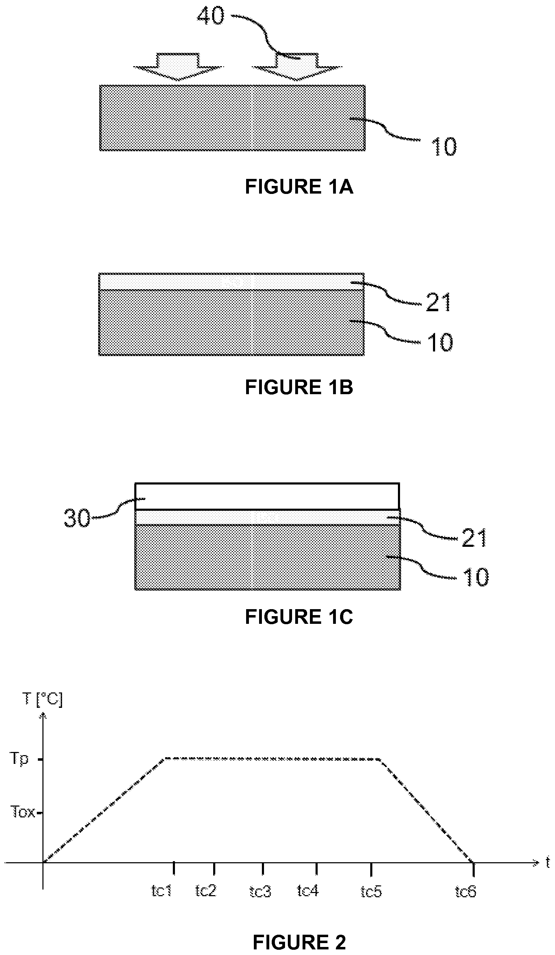

Les figures 1A à 1C illustrent la fabrication d'un substrat support connu. Typiquement, en référence à la figure 1A, on forme la couche de passivation 21 par oxydation du substrat de base 10 par apport d'un gaz oxydant 40 dans une enceinte à une température supérieure à 1000°C. Ensuite, en référence à la figure 1B, sans extraire le substrat comportant la couche de passivation de l'enceinte, on évacue le gaz oxydant. En référence à la figure 1C, on forme la couche de piégeage de charges 30 dans la même enceinte.

En référence à la figure 2, un tel procédé nécessite une première phase de recuit dans l'intervalle entre tc1 et tc2 visant à dégrader entièrement la couche d'oxyde natif qui se forme naturellement sur le substrat lors du contact avec l'air ambiant avant le dépôt d'autres couches. Le procédé comprend en outre une phase d'oxydation entre tc2 et tc3 et une phase d'évacuation entre tc3 et tc4 du gaz oxydant avant la réalisation de la couche de piégeage de charges entre tc4 et tc5. Le procédé se termine à tc6 après le refroidissement du substrat support. Toutes ces étapes sont typiquement réalisées à une température élevée Tₚ supérieure à 1000°C, typiquement à la même température que le dépôt de la couche de piégeage de charges. Un tel procédé est long et implique donc une haute consommation d'énergie et une immobilisation de l'enceinte de dépôt.

Le document US 2003/0097977 A1 propose un autre procédé de fabrication d'un tel substrat. Selon ce procédé, on forme par épitaxie sur un substrat de base une couche ayant les mêmes qualités cristallines que le substrat de base. Par la suite, un agent réactif est introduit dans l'enceinte d'épitaxie afin de transformer la couche épitaxiale en une couche d'oxyde. De telles étapes de dépôt et d'oxydation sont complexes et prolongent le temps nécessaire pour la fabrication du substrat.

Le document US 2017/040210 A1 décrit un procédé de fabrication d'une plaquette SOI collée, comprenant les étapes suivantes : - dépôt d'une couche de silicium polycristallin sur la face de collage de la plaquette de base ; - polissage de la surface de la couche de silicium polycristallin ; - formation d'un film isolant sur la face de collage de la plaquette de collage ; - collage de la surface polie de la couche de silicium polycristallin de la plaquette de base et de la plaquette de collage à l'aide du film isolant ; et - amincissement de la plaquette de collage pour former une couche SOI. Le procédé comprend en outre une étape de formation d'un film d'oxyde sur la surface de la plaquette de base, sur lequel la couche de silicium polycristallin est déposée à l'étape suivante.

### EXPOSE DE L'INVENTION

Un but de l'invention est de proposer un procédé de fabrication d'un substrat support comprenant une couche de passivation et une couche de piégeage de charges plus simple et plus rapide.

A cet effet, l'invention propose un procédé de fabrication d'un substrat support comprenant une couche de piégeage de charges pour une structure de type semi-conducteur sur isolant ou piézoélectrique sur isolant pour application radiofréquences, comprenant :
- la mise en place d'un substrat de base comprenant une couche d'oxyde de silicium natif dans une chambre de dépôt,
- la montée en température de la chambre de dépôt jusqu'à une température de dépôt de la couche de piégeage de charges,
- l'introduction d'un gaz oxydant dans ladite chambre de dépôt pour conserver la couche d'oxyde de silicium natif pendant la montée en température,
- l'évacuation de l'oxygène de la chambre de dépôt à la température de formation de la couche de piégeage de charges,
- le dépôt, dans la chambre de dépôt, de la couche de piégeage de charges en silicium polycristallin sur la couche d'oxyde de silicium natif.

L'apport d'un gaz oxydant dans l'enceinte permet de conserver la couche d'oxyde natif afin de former la couche de silicium polycristallin directement sur cette couche, sans avoir à déposer une nouvelle couche d'oxyde de silicium. Par conséquent, la durée du procédé à haute température est réduite. Cela permet d'économiser de l'énergie de chauffage et de réutiliser l'enceinte plus rapidement pour la fabrication d'autres substrats.

Dans certains modes de réalisation, le procédé comprend en outre la formation d'une seconde couche d'oxyde de silicium entre la première couche d'oxyde de silicium natif et le substrat de base.

De préférence, l'épaisseur totale de la ou les couches d'oxyde de silicium est comprise entre 0,5 et 1,5 nm.

Le temps écoulé entre la fin de l'évacuation d'oxygène et le début du dépôt de la couche de piégeage de charges est supérieur à 30 secondes.

De préférence, la température de dépôt de la couche de piégeage de charges est supérieure à 950°C.

De manière avantageuse, le gaz oxydant comprend de l'oxygène ou un mélange d'argon et d'oxygène.

Avantageusement, le substrat de base est en silicium monocristallin. De préférence, la couche de piégeage de charges est en silicium polycristallin.

Dans certains modes de réalisation, la formation de la couche de piégeage de charges est réalisée par un procédé de dépôt chimique en phase vapeur.

L'invention se rapporte également à un procédé de fabrication d'une structure de type semi-conducteur sur isolant pour applications radiofréquences, caractérisé en ce qu'il comprend les étapes suivantes :
- la fabrication d'un substrat support par un procédé tel que décrit ci-dessus,
- la mise à disposition d'un substrat donneur semi-conducteur ou piézoélectrique,
- la formation d'une couche électriquement isolante sur la couche de piégeage de charges et/ou sur ledit substrat donneur,
- le collage du substrat donneur sur le substrat support par l'intermédiaire de la couche électriquement isolante ,
- le transfert de la couche semi-conductrice ou piézoélectrique sur le substrat support, la couche électriquement isolante étant agencée à l'interface entre la couche semi-conductrice ou piézoélectrique transférée et la couche de piégeage de charges.

Dans certains modes de réalisation, ledit procédé comprend en outre une étape de formation d'une zone de fragilisation dans le substrat donneur de sorte à délimiter une couche semi-conductrice ou piézoélectrique à transférer, et le transfert de la couche semi-conductrice ou piézoélectrique sur le substrat support comprend le détachement du substrat donneur le long de ladite zone de fragilisation.

Dans certains modes de réalisation, le procédé peut comprendre, avant l'étape de formation de la zone de fragilisation dans le substrat donneur, une étape de collage dudit substrat donneur sur un substrat temporaire de sorte à former un substrat dit pseudo-donneur, et l'étape de collage comprend alors le collage dudit substrat pseudo-donneur sur le substrat support par l'intermédiaire de la couche électriquement isolante.

Dans d'autres modes de réalisation, le transfert de la couche semi-conductrice ou piézoélectrique sur le substrat support comprend un amincissement du substrat donneur par le côté opposé à la couche électriquement isolante.

Dans certaines applications, le substrat donneur est semi-conducteur et comprend du silicium.

Dans d'autres applications, le substrat donneur est piézoélectrique et comprend un composé de formule ABO₃, où A est choisi parmi le baryum et le lithium et B est choisi parmi le tantale, le titane et le niobium.

### BREVE DESCRIPTION DES FIGURES

D'autres caractéristiques et avantages de l'invention ressortiront de la description détaillée qui va suivre, en référence aux dessins annexés, sur lesquels :
La figure 1A illustre un procédé de fabrication d'une couche de passivation connu.
La figure 1B illustre un substrat support comportant une couche de passivation fabriqué dans le procédé de la figure 1A.
La figure 2 est le profil de température d'un procédé de fabrication d'un substrat support connu.
La figure 3A et la figure 3B illustrent un procédé de fabrication d'une couche de passivation selon l'invention.
La figure 3C illustre un substrat support comportant une couche de passivation.
La figure 4 montre le taux de réaction en fonction de la température.
La figure 5 illustre un procédé de fabrication d'une couche de passivation selon un deuxième mode de réalisation.
La figure 6 montre l'épaisseur d'oxyde de silicium formé en fonction de la température.
La figure 7 est le profil de température d'un procédé de fabrication d'un substrat support connu et un procédé selon l'invention.
Les figures 8A à 8E illustrent un premier procédé de fabrication d'un substrat du type semiconducteur sur isolant ou piézoélectrique sur isolant à partir d'un substrat support selon l'invention.
Les figures 9A à 9D illustrent une variante de réalisation du procédé des figures 8A à 8E, mettant en oeuvre la formation d'un pseudo-substrat donneur.
Les figures 10A à 10C illustrent un deuxième procédé de fabrication d'un substrat du type semiconducteur sur isolant ou piézoélectrique sur isolant à partir d'un substrat support selon l'invention.

### DESCRIPTION DETAILLEE DE MODES DE REALISATION

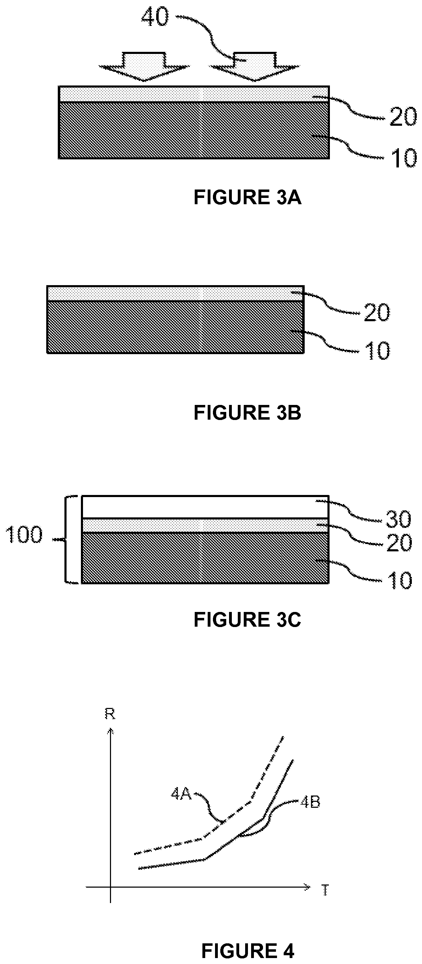

Les figures 3A à 3C illustrent la fabrication d'un substrat support selon un premier mode de réalisation de l'invention. En référence à la figure 3A, on commence par la mise à disposition d'un substrat de base 10 qui comporte une couche 20 d'oxyde de silicium natif. Typiquement, ce substrat peut être en silicium monocristallin. Une telle couche d'oxyde natif 20 se forme lors du contact avec de l'air comportant de l'oxygène après la fabrication du substrat support 10, par exemple après sa découpe à partir d'un lingot. Cette couche d'oxyde natif est donc présente sur tous les substrats en silicium exposés à l'air ambiant. L'épaisseur de la couche d'oxyde de silicium natif 20 est typiquement comprise entre 0,5 et 1 nm.

On place le substrat support 10 avec la couche d'oxyde natif 20 dans une chambre de dépôt adaptée pour le dépôt d'une couche de piégeage de charges 30. Une telle enceinte est typiquement une enceinte de dépôt chimique en phase vapeur (CVD, acronyme du terme anglo-saxon « Chemical Vapor Deposition »). Cependant, l'invention ne se limite pas à un procédé dans une enceinte de CVD et une couche de piégeage de charges 30 déposée par CVD. Le procédé peut s'appliquer à un substrat de base 10 sur lequel une couche de piégeage de charges 30 est déposée par toute technique nécessitant une montée en température susceptible de dégrader la couche d'oxyde de silicium natif 20 présente sur le substrat de base 10.

On chauffe le substrat de base 10 comportant la couche d'oxyde natif 20 progressivement de la température ambiante qui est typiquement proche de 20°C jusqu'à une température Tₚ de dépôt de la couche de piégeage de charges. Cette température Tₚ est typiquement supérieure à 950°C.

Pendant le chauffage, on évacue les gaz extérieurs qui peuvent être introduits dans la chambre de dépôt lors de l'introduction du substrat de base. On introduit ensuite un gaz oxydant 40 dans la chambre de dépôt afin de conserver la couche d'oxyde de silicium natif 20 pendant la montée en température. Un tel gaz oxydant 40 peut être de l'oxygène (O₂) ou un mélange d'un gaz porteur inerte avec de l'oxygène, par exemple un mélange d'argon et d'oxygène. On commence l'introduction du gaz oxydant 40 dans la chambre à une température Tₒₓ comprise entre 700 et 950°C afin d'éviter la dégradation de la couche d'oxyde de silicium natif 20 qui se produit à des températures plus élevées. Le débit d'oxygène assure la conservation de la couche d'oxyde de silicium natif 20 pendant la montée en température jusqu'à la température Tₚ de dépôt de la couche de piégeage de charges 30. La couche d'oxyde de silicium natif 20 reste donc en place sur la surface du substrat de base 10 et peut être utilisée en tant que couche de passivation entre le substrat de base 10 et une couche de piégeage de charges 30.

Pendant la stabilisation de la température à la température Tₚ de dépôt, et avant de former une couche de piégeage de charges 30, on évacue le gaz oxydant 40 de l'enceinte de dépôt. A partir de l'évacuation du gaz oxydant 40, la couche d'oxyde de silicium natif 20 commence à se dégrader en raison de la température élevée à laquelle ladite couche est exposée. On procède donc au dépôt de la couche de piégeage de charges 30 rapidement après l'évacuation du gaz oxydant. Cependant, il est nécessaire d'assurer une bonne évacuation de l'oxygène et une stabilisation de la température Tₚ, pour le dépôt de la couche de piégeage de charges 30. Afin d'éviter une dégradation trop importante de la couche de d'oxyde de silicium natif 20, le délai entre l'évacuation complète du gaz oxydant 40 et le début de la formation de la couche de piégeage de charges 30 est avantageusement compris entre 5 et 100 secondes.

En référence à la figure 3C, on forme la couche de piégeage de charges 30 dans la même enceinte. La couche de piégeage de charges 30 est typiquement en silicium polycristallin. Le dépôt de cette couche typiquement est réalisé par un procédé de dépôt chimique en phase vapeur (CVD).

Après le dépôt de la couche de piégeage de charges 30, le substrat support 100 est achevé et peut être utilisé pour la réalisation d'une structure de type semi-conducteur sur isolant.

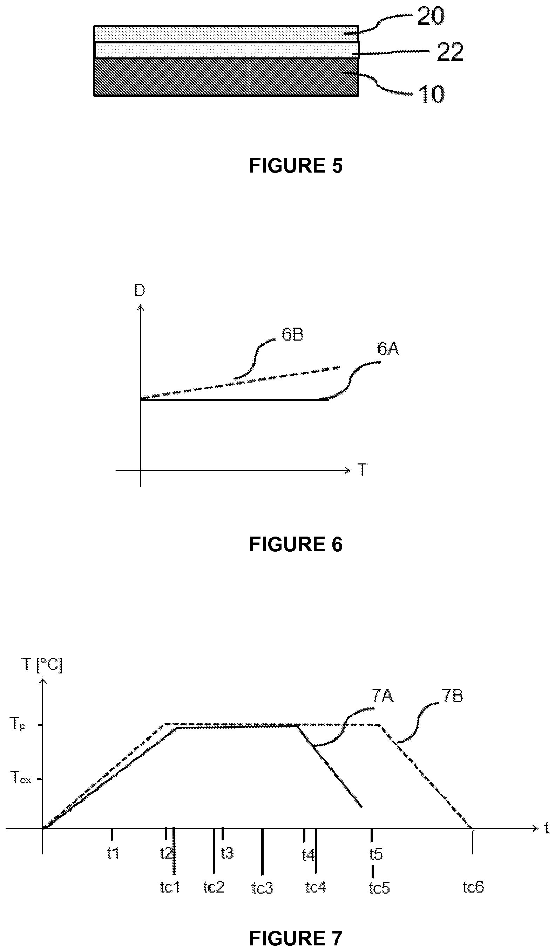

La figure 4 montre le taux de réaction R en fonction de la température pendant la même étape de montée en température pendant l'apport du gaz oxydant, réalisée dans le temps entre t1 et t2 comme illustré à la figure 5. La courbe 4A indique le taux d'oxydation du silicium monocristallin du substrat de base en raison du flux de gaz oxydant introduit dans la chambre de dépôt (ce taux d'oxydation induisant une augmentation de l'épaisseur de la couche d'oxyde de silicium). La courbe 4B correspond à la dégradation de la couche d'oxyde en raison de la montée en température (ce taux de dégradation induisant une diminution de l'épaisseur de la couche d'oxyde de silicium). Les deux courbes évoluent de manière parallèle. Ainsi, les deux phénomènes concurrents se compensent mutuellement, assurant ainsi une épaisseur stable de la couche d'oxyde de silicium sur le substrat de base. La couche d'oxyde natif est conservée pendant ce procédé.

Un deuxième mode de réalisation est illustré dans la figure 5. Les éléments désignés par les mêmes signes de référence que sur les figures 3A à 3C sont identiques ou remplissent la même fonction que les éléments déjà décrits dans le premier mode de réalisation et ne seront donc pas décrits à nouveau.

On met à disposition un substrat de base 10 qui comporte une couche d'oxyde de silicium natif 20. On chauffe le substrat de base 10 dans une enceinte de dépôt sous un flux d'un gaz oxydant 40. Le débit et la concentration d'oxygène dans le gaz oxydant 40 sont choisis de sorte que la quantité d'oxygène apportée soit plus grande que dans le premier cas. Cela permet de favoriser le phénomène d'oxydation par rapport au phénomène de dégradation de la couche d'oxyde. Ainsi, l'apport d'une quantité suffisamment élevée d'oxygène permet non seulement de conserver la couche d'oxyde de silicium natif 20 mais aussi de provoquer la formation d'une couche supplémentaire 22 en oxyde de silicium à l'interface entre le substrat de base 10 et la couche d'oxyde natif 20. Cette couche supplémentaire 22 est réalisée par l'oxydation d'une partie du silicium à la surface du substrat de base 10, en dessous de la couche d'oxyde de silicium natif 20. La couche initiale en oxyde de silicium natif est ainsi épaissie d'une couche supplémentaire 22 pour obtenir une épaisseur totale d'oxyde de silicium plus importante.

La couche de passivation est ainsi composée d'une portion en oxyde de silicium natif 20 et une portion 22 en oxyde de silicium formé par oxydation pendant la montée en température dans un flux de gaz oxydant 40. Une telle couche de passivation présente une épaisseur totale comprise entre 0,6 et 1,6 nm.

On évacue ensuite le gaz oxydant 40 de la même manière que dans le mode de réalisation décrit ci-dessus, pendant la phase de stabilisation de la température Tₚ de dépôt de la couche de piégeage de charges 30. La couche de piégeage de charges 30 est déposée après la stabilisation de la température Tₚ et l'évacuation complète du gaz oxydant 40.

Ce deuxième mode de réalisation est particulièrement adapté lorsque la couche d'oxyde natif 20 est relativement fine ou lorsqu'une partie de la couche de passivation risque de subir une dégradation avant le dépôt de la couche de piégeage de charges.

La figure 6 illustre l'épaisseur totale D de la couche d'oxyde sur le substrat de base pendant la fabrication du substrat support en fonction de la température T pendant la montée en température. Pour le premier mode de réalisation, en référence à la courbe 6A, l'épaisseur de la couche d'oxyde est sensiblement constante. Cette épaisseur correspond à l'épaisseur de la couche d'oxyde de silicium natif présent sur le substrat de base. Dans le deuxième mode de réalisation, en référence à la courbe 6B, l'épaisseur de la couche est égale à l'épaisseur de la couche d'oxyde natif au début du procédé, au moment de l'introduction du gaz oxydant dans la chambre de dépôt. L'épaisseur de la couche d'oxyde natif reste également sensiblement constante pendant ce procédé. En parallèle, la couche d'oxyde supplémentaire 22 se forme par l'oxydation d'une partie du silicium à la surface du substrat de base. L'épaisseur de la couche supplémentaire 22 augmente de manière linéaire. Cette épaisseur s'ajoute à l'épaisseur de la couche d'oxyde natif déjà présente sur le substrat de base.

### Evolution du substrat de base dans le temps

La figure 7 montre le profil de température 7A d'un procédé selon l'invention en comparaison avec le profil de température 7B d'un procédé de fabrication d'un substrat support connu. Le profil 7B est identique au profil d'un procédé connu illustré dans la figure 2. Dans le procédé selon l'invention, en référence au profil 7A, on introduit le gaz oxydant 40 dans le four au moment t1 à la température Tₒₓ. Au moment t2, on atteint la température Tₚ de dépôt de la couche de piégeage de charges. Dans l'intervalle entre t2 et t3, on évacue le gaz oxydant 40 de l'enceinte de dépôt. On procède ensuite au dépôt de la couche de piégeage de charges qui se termine à t4. Après le refroidissement, à t5, le substrat support est finalisé et peut être retiré de l'enceinte de dépôt. Dans le procédé connu, en référence au profil 5B, le dépôt de la couche de piégeage de charges se termine à tc5 comme décrit ci-dessus. Le temps t5 correspond au temps tc5 de début de dépôt de la couche de piégeage de charges dans un procédé connu.

Comparé au procédé connu, le procédé selon l'invention peut être achevé en 70% à 85% du temps. Par ailleurs, la phase oxydante est réalisée à plus basse température et à plus bas débit d'oxygène que dans le procédé connu. Cela engendre moins de dégradation à l'intérieur de l'enceinte.

### Fabrication d'une structure de type semi-conducteur sur isolant ou piézoélectrique sur isolant

On va maintenant décrire les étapes pour la réalisation d'une structure de type semi-conducteur sur isolant ou piézoélectrique sur isolant pour application radiofréquences. Une telle structure comprend un substrat support réalisé selon un procédé tel que décrit ci-dessus, une couche semiconductrice ou piézoélectrique sur sa surface, et une couche électriquement isolante qui est agencée à l'interface entre le substrat support et la couche superficielle semiconductrice ou piézoélectrique.

La fabrication d'une telle structure met typiquement en oeuvre un assemblage d'un substrat donneur semiconducteur ou piézoélectrique sur le substrat support, la couche électriquement isolante étant agencée à l'interface entre les deux substrats, et un transfert d'une couche semi-conductrice ou piézoélectrique dudit substrat donneur sur le substrat support. Différents procédés de transfert de couche peuvent être mis en oeuvre.

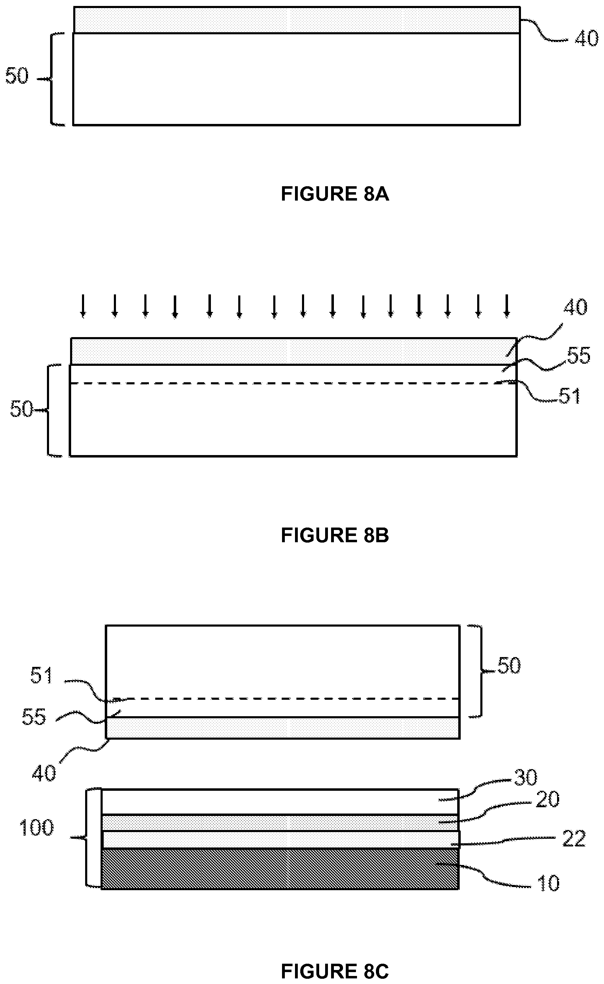

Les figures 8A-8E illustrent schématiquement des étapes d'une première forme d'exécution du procédé de fabrication de la structure, utilisant le procédé dit Smart Cut^{™}.

En référence à la figure 8A, on commence par la mise à disposition d'un substrat donneur 50 semiconducteur à partir duquel une couche semiconductrice 55 sera transférée sur le substrat support 100. Le matériau semiconducteur du substrat donneur est avantageusement du silicium. On forme une couche électriquement isolante 40 sur la surface du substrat donneur 50.

En référence à la figure 8B, comme schématisé par les flèches, on met en oeuvre une implantation d'espèces ioniques, telles que de l'hydrogène et/ou de l'hélium, au travers de la couche électriquement isolante 40, de sorte à former une zone de fragilisation 51 dans le substrat donneur 50. Ladite zone de fragilisation 51 définit la couche semi-conductrice 55 à transférer.

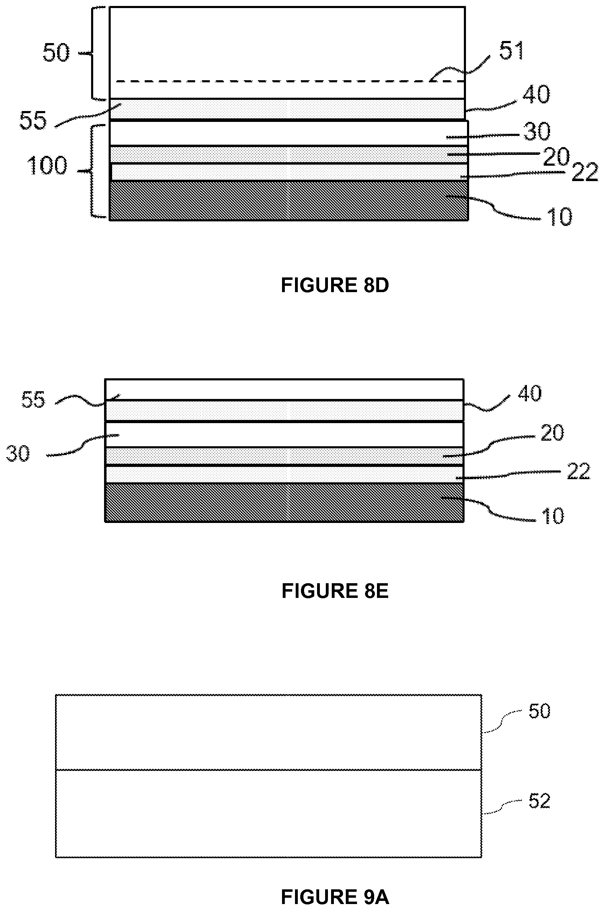

En référence à la figure 8C et la figure 8D, on colle le substrat donneur 50 ainsi implanté sur la couche de piégeage de charges 30 du substrat support 100 par l'intermédiaire de la couche électriquement isolante 40. Cette dernière devient alors une couche d'oxyde enterrée 40.

De manière alternative, la couche électriquement isolante 40 peut être formée sur le substrat support 100, et le substrat donneur 50 comprenant la zone de fragilisation 51 peut être collé sur le substrat support 100 comportant la couche électriquement isolante 40.

En référence à la figure 8E, on détache le substrat donneur 50 le long de la zone de fragilisation 51, ce qui conduit au transfert de la couche semi-conductrice 55 sur le substrat support 100, la couche électriquement isolante 40 étant agencée entre le substrat support 100 et la couche semi-conductrice 55. On peut par la suite mettre en oeuvre un traitement de finition de la couche transférée 55, de sorte à guérir les défauts liés à l'implantation et à lisser la surface libre de ladite couche 55. La structure de type semi-conducteur sur isolant ainsi obtenue peut être utilisée pour la fabrication de composants pour application radiofréquences.

Les étapes décrites ci-dessus s'appliquent de manière similaire à la formation d'une structure de type piézoélectrique sur isolant. Dans ce cas, le substrat donneur comprend au moins une portion en un matériau piézoélectrique dans lequel est prélevée la couche à transférer.

Ledit matériau piézoélectrique est choisi avantageusement parmi les composés de formule ABO₃, où A est choisi parmi le baryum et le lithium et B est choisi parmi le titane, le tantale et le niobium (par exemple le niobate de lithium (LiNbO₃), le tantalate de lithium (LiTaO₃), le titanate de baryum (BaTiO₃)). D'autres matériaux piézoélectriques utilisables dans la présente invention sont, de manière non limitative, le niobate de potassium-sodium (KₓNa1₋ₓNbO₃ avec 0<x<1, ou KNN), le quartz, le titano-zirconate de plomb (PZT), un composé de niobate de plomb-magnésium et de titanate de plomb (PMN-PT), l'oxyde de zinc (ZnO), le nitrure d'aluminium (AIN) ou le nitrure d'aluminium et de scandium (AlScN).

Dans certaines situations, il n'est pas possible de transférer directement une couche du substrat donneur sur le substrat support, notamment en raison de contraintes liées au procédé Smart Cut^{™}. Plus particulièrement, pour obtenir le détachement du substrat donneur le long de la zone de fragilisation, il est généralement nécessaire de procéder à un recuit, dans une plage de température de 100°C à 600°C. Lorsque le substrat donneur et le substrat support ont des coefficients de dilatation thermiques différents - ce qui est le cas par exemple entre un substrat donneur en un matériau piézoélectrique et un substrat support principalement en silicium - ledit recuit engendre une déformation significative (« bow » selon la terminologie anglo-saxonne) de l'assemblage des deux substrats, qui est préjudiciable au transfert dans la mesure où elle peut induire une casse des substrats.

Pour minimiser une telle déformation, il est possible de former un substrat intermédiaire dit pseudo-substrat donneur, dans lequel le substrat donneur est assemblé sur un substrat temporaire.

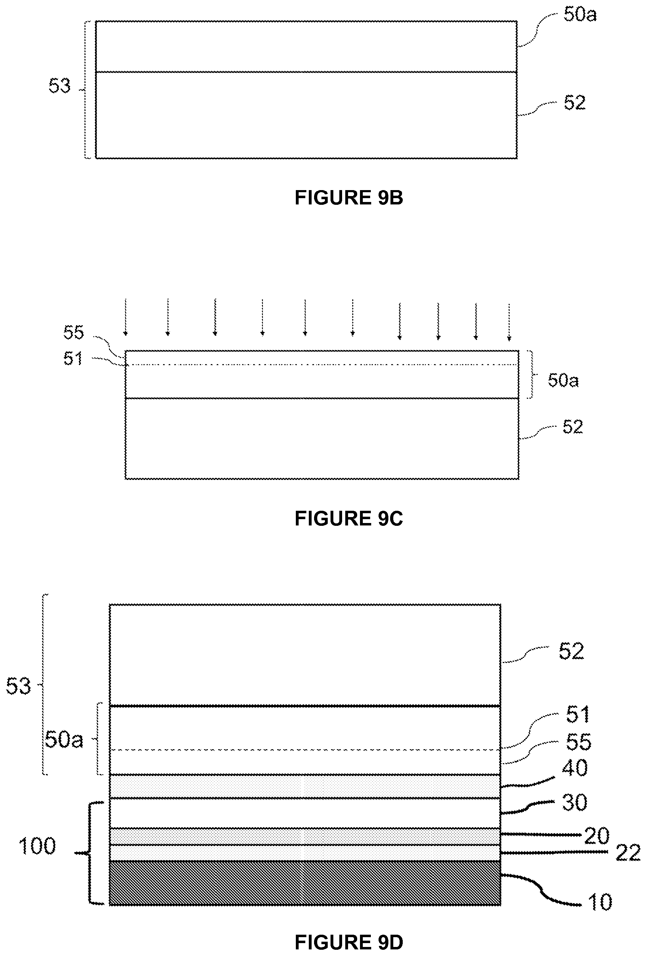

Comme illustré sur les figures 9A-9D, le procédé de fabrication de la structure de type POI ou SOI comprend alors une étape préalable de formation d'un pseudo-substrat donneur 52, par collage du substrat donneur 50 sur un substrat temporaire 52 (cf. figure 9A) et une éventuelle étape d'amincissement du substrat donneur 50 (cf. figure 9B). Le collage du substrat donneur sur le substrat temporaire peut être réalisé par adhésion moléculaire ou par l'intermédiaire d'une couche polymérique telle que décrite dans le document WO 2019/186032, auquel on pourra se référer pour une description du procédé de formation de ladite couche polymérique.

En référence à la figure 9C, une étape d'implantations d'espèces atomiques est réalisée sur le pseudo-substrat donneur 53 ainsi obtenu pour former une zone de fragilisation 51 délimitant la couche 55 à transférer au sein du substrat donneur aminci 50a.

Ensuite, comme illustré sur la figure 9D, le pseudo-substrat donneur est collé sur le substrat support 100, une couche électriquement isolante 40 étant agencée à l'interface de collage, puis une étape de détachement du pseudo-substrat donneur le long de la zone de fragilisation 51 est mise en oeuvre pour transférer la couche 55 sur le substrat support 100. On obtient alors la structure déjà illustrée sur la figure 8E.

De manière particulièrement avantageuse, le substrat temporaire présente un coefficient de dilatation thermique proche de celui du substrat support, c'est-à-dire typiquement une différence de coefficient de dilatation thermique nulle ou en valeur absolue inférieure à 5%. Par exemple, le substrat temporaire peut être en silicium. Ainsi, lors du recuit mis en oeuvre pour détacher le substrat donneur le long de la zone de fragilisation, les deux substrats situés de part et d'autre du substrat donneur se déforment avec une amplitude sensiblement identique, ce qui évite de déformer l'assemblage.

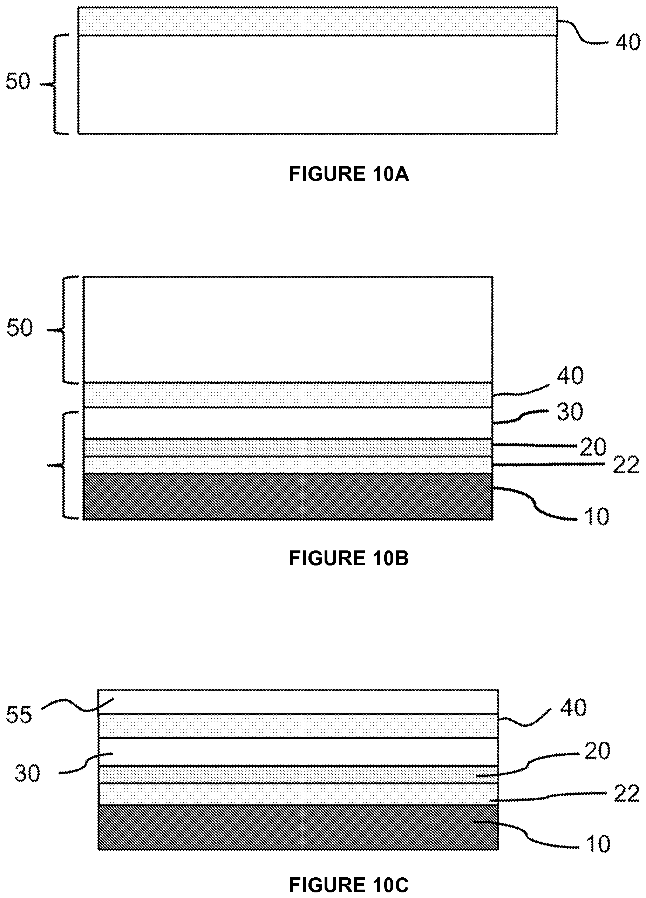

Les figures 10A-10C illustrent schématiquement des étapes d'une deuxième forme d'exécution du procédé de fabrication de la structure, notamment en vue de la fabrication d'une structure de type piézoélectrique sur isolant.

En référence à la figure 10A, on met à disposition un substrat donneur 50 à partir duquel une couche 55 sera transférée sur le substrat support 100. On forme une couche électriquement isolante 40 sur la surface du substrat donneur 50.

En référence à la figure 10B, on colle le substrat donneur 50 sur la couche de piégeage de charges 30 du substrat support 100 par l'intermédiaire de la couche électriquement isolante 40. Cette dernière devient alors une couche d'oxyde enterrée 40.

De manière alternative, la couche électriquement isolante 40 peut être formée sur le substrat support 100, et le substrat donneur 50 peut être collé sur le substrat support 100 comportant la couche électriquement isolante 40.

En référence à la figure 10C, on amincit le substrat donneur 50 par sa face opposée à l'interface de collage, par exemple par meulage, jusqu'à atteindre l'épaisseur souhaitée pour la couche 55. On transfère ainsi la couche 55 sur le substrat support 100, la couche électriquement isolante 40 étant agencée entre le substrat support 100 et la couche semi-conductrice 55. On peut par la suite mettre en œuvre un traitement de finition de la couche transférée 55, par exemple un polissage de la surface libre de ladite couche 55. La structure ainsi obtenue peut être utilisée pour la fabrication de composants pour application radiofréquences.

### REFERENCES

US 2003/0097977 A1

## Revendications

1. Procédé de fabrication d'un substrat support comprenant une couche de piégeage de charges pour une structure de type semi-conducteur sur isolant ou piézoélectrique sur isolant pour application radiofréquences, comprenant :
∘ la mise en place d'un substrat de base (10) comprenant une couche (20) d'oxyde de silicium natif dans une chambre de dépôt,
∘ la montée en température de la chambre de dépôt jusqu'à une température (Tₚ) de dépôt de la couche de piégeage de charges (30),
∘ l'introduction d'un gaz oxydant dans ladite chambre de dépôt pour conserver la couche (20) d'oxyde de silicium natif pendant la montée en température,
∘ l'évacuation de l'oxygène de la chambre de dépôt à la température (Tₚ) de formation de la couche de piégeage de charges (30),
∘ le dépôt, dans la chambre de dépôt, de la couche de piégeage de charges (30) en silicium polycristallin sur la couche (20) d'oxyde de silicium natif.

2. Procédé selon la revendication 1, comprenant en outre la formation d'une seconde couche (22) d'oxyde de silicium entre la première couche d'oxyde de silicium natif (20) et le substrat de base (10).

3. Procédé selon la revendication 1 ou la revendication 2, dans lequel l'épaisseur totale de la ou les couches d'oxyde de silicium (20, 22) est comprise entre 0,5 et 1,5 nm.

4. Procédé selon l'une des revendications précédentes, dans lequel le temps écoulé entre la fin de l'évacuation d'oxygène et le début du dépôt de la couche de piégeage de charges est supérieur à 30 secondes.

5. Procédé selon l'une des revendications précédentes, dans lequel la température de dépôt de la couche de piégeage de charges est supérieure à 950°C.

6. Procédé selon l'une des revendications précédentes, dans lequel le gaz oxydant comprend de l'oxygène ou un mélange d'argon et d'oxygène.

7. Procédé selon l'une des revendications précédentes, dans lequel le substrat de base est en silicium monocristallin.

8. Procédé selon l'une des revendications précédentes, dans lequel la couche de piégeage de charges est en silicium polycristallin.

9. Procédé selon l'une des revendications précédentes, dans lequel la formation de la couche de piégeage de charges est réalisée par un procédé de dépôt chimique en phase vapeur (CVD).

10. Procédé de fabrication d'une structure de type semi-conducteur sur isolant ou piézoélectrique sur isolant pour applications radiofréquences, **caractérisé en ce qu'**il comprend les étapes suivantes :
• la fabrication d'un substrat support (100) par un procédé selon l'une quelconque des revendications précédentes,
• la mise à disposition d'un substrat donneur (50) semi-conducteur ou piézoélectrique,
• la formation d'une couche électriquement isolante (40) sur la couche de piégeage de charges (30) et/ou sur ledit substrat donneur (50),
• le collage du substrat donneur (50) sur le substrat support par l'intermédiaire de la couche électriquement isolante ,
• le transfert de la couche semi-conductrice ou piézoélectrique (55) sur le substrat support (100), la couche électriquement isolante (40) étant agencée à l'interface entre la couche semi-conductrice ou piézoélectrique (55) transférée et la couche de piégeage de charges (30).

11. Procédé selon la revendication 10, comprenant en outre une étape de formation d'une zone de fragilisation (51) dans le substrat donneur (50) de sorte à délimiter une couche semi-conductrice ou piézoélectrique (55) à transférer, et dans lequel le transfert de la couche semi-conductrice ou piézoélectrique (55) sur le substrat support comprend le détachement du substrat donneur (50) le long de ladite zone de fragilisation (51).

12. Procédé selon la revendication 11, comprenant, avant l'étape de formation de la zone de fragilisation dans le substrat donneur, une étape de collage dudit substrat donneur (50) sur un substrat temporaire (52) de sorte à former un substrat dit pseudo-donneur (53), et dans lequel l'étape de collage comprend le collage dudit substrat pseudo-donneur (53) sur le substrat support (100) par l'intermédiaire de la couche électriquement isolante (40).

13. Procédé selon la revendication 10, dans lequel le transfert de la couche semi-conductrice ou piézoélectrique (55) sur le substrat support comprend un amincissement du substrat donneur par le côté opposé à la couche électriquement isolante.

14. Procédé selon l'une des revendications 10 à 13, dans lequel le substrat donneur est semi-conducteur et comprend du silicium.

15. Procédé selon l'une des revendications 10 à 13, dans lequel le substrat donneur est piézoélectrique et comprend un composé de formule ABO₃, où A est choisi parmi le baryum et le lithium et B est choisi parmi le tantale, le titane et le niobium.

## Patentansprüche

1. Verfahren zur Herstellung eines Trägersubstrats, das eine Ladungsfalle-Schicht für eine Struktur vom Typ Halbleiter-auf-Isolator oder Piezoelektrikum-auf-Isolator für Hochfrequenzanwendungen umfasst, umfassend:
• das Einbringen eines Basissubstrats (10), das eine Schicht (20) aus nativem Siliziumoxid umfasst, in eine Abscheidekammer,
• das Aufheizen der Abscheidekammer bis zu einer Temperatur (Tp) zur Abscheidung der Ladungsfalle-Schicht (30),
• das Einführen eines Oxidationsgases in die genannte Abscheidekammer, um die Schicht (20) aus nativem Siliziumoxid während des Aufheizens zu erhalten,
• das Entfernen des Sauerstoffs aus der Abscheidekammer bei der Temperatur (Tp) zur Bildung der Ladungsfalle-Schicht (30),
• die Abscheidung der Ladungsfalle-Schicht (30) aus polykristallinem Silizium in der Abscheidekammer auf der Schicht (20) aus nativem Siliziumoxid.

2. Verfahren nach Anspruch 1, weiterhin umfassend die Bildung einer zweiten Schicht (22) aus Siliziumoxid zwischen der ersten Schicht aus nativem Siliziumoxid (20) und dem Basissubstrat (10).

3. Verfahren nach Anspruch 1 oder Anspruch 2, wobei die Gesamtdicke der Siliziumoxid-Schicht oder -Schichten (20, 22) zwischen 0,5 und 1,5 nm beträgt.

4. Verfahren nach einem der vorhergehenden Ansprüche, wobei die zwischen dem Ende des Entfernens von Sauerstoff und dem Beginn der Abscheidung der Ladungsfalle-Schicht verstrichene Zeit größer als 30 Sekunden ist.

5. Verfahren nach einem der vorhergehenden Ansprüche, wobei die Abscheidetemperatur der Ladungsfalle-Schicht größer als 950°C ist.

6. Verfahren nach einem der vorhergehenden Ansprüche, wobei das Oxidationsgas Sauerstoff oder ein Gemisch aus Argon und Sauerstoff umfasst.

7. Verfahren nach einem der vorhergehenden Ansprüche, wobei das Basissubstrat aus monokristallinem Silizium besteht.

8. Verfahren nach einem der vorhergehenden Ansprüche, wobei die Ladungsfalle-Schicht aus polykristallinem Silizium besteht.

9. Verfahren nach einem der vorhergehenden Ansprüche, wobei die Bildung der Ladungsfalle-Schicht durch ein chemisches Gasphasenabscheidungsverfahren (CVD) durchgeführt wird.

10. Verfahren zur Herstellung einer Struktur vom Typ Halbleiter-auf-Isolator oder Piezoelektrikum-auf-Isolator für Hochfrequenzanwendungen, **dadurch gekennzeichnet, dass** es die folgenden Schritte umfasst:
• die Herstellung eines Trägersubstrats (100) durch ein Verfahren nach einem der vorhergehenden Ansprüche,
• die Bereitstellung eines Donorsubstrats (50), das halbleitend oder piezoelektrisch ist,
• die Bildung einer elektrisch isolierenden Schicht (40) auf der Ladungsfalle-Schicht (30) und/oder auf dem genannten Donorsubstrat (50),
• das Verbinden des Donorsubstrats (50) mit dem Trägersubstrat mittels der elektrisch isolierenden Schicht,
• das Übertragen der halbleitenden oder piezoelektrischen Schicht (55) auf das Trägersubstrat (100), wobei die elektrisch isolierende Schicht (40) an der Grenzfläche zwischen der übertragenen halbleitenden oder piezoelektrischen Schicht (55) und der Ladungsfalle-Schicht (30) angeordnet ist.

11. Verfahren nach Anspruch 10, weiterhin umfassend einen Schritt der Bildung einer Schwächungszone (51) im Donorsubstrat (50), um eine zu übertragende halbleitende oder piezoelektrische Schicht (55) zu begrenzen, und wobei das Übertragen der halbleitenden oder piezoelektrischen Schicht (55) auf das Trägersubstrat das Abtrennen des Donorsubstrats (50) entlang der genannten Schwächungszone (51) umfasst.

12. Verfahren nach Anspruch 11, umfassend, vor dem Schritt der Bildung der Schwächungszone im Donorsubstrat, einen Schritt des Verbindens des genannten Donorsubstrats (50) mit einem temporären Substrat (52), um ein sogenanntes Pseudo-Donorsubstrat (53) zu bilden, und wobei der Schritt des Verbindens das Verbinden des genannten Pseudo-Donorsubstrats (53) mit dem Trägersubstrat (100) mittels der elektrisch isolierenden Schicht (40) umfasst.

13. Verfahren nach Anspruch 10, wobei das Übertragen der halbleitenden oder piezoelektrischen Schicht (55) auf das Trägersubstrat ein Ausdünnen des Donorsubstrats von der der elektrisch isolierenden Schicht gegenüberliegenden Seite umfasst.

14. Verfahren nach einem der Ansprüche 10 bis 13, wobei das Donorsubstrat halbleitend ist und Silizium umfasst.

15. Verfahren nach einem der Ansprüche 10 bis 13, wobei das Donorsubstrat piezoelektrisch ist und eine Verbindung der Formel ABO₃ umfasst, wobei A aus Barium und Lithium ausgewählt ist und B aus Tantal, Titan und Niob ausgewählt ist.

## Claims

1. Method for manufacturing a support substrate comprising a charge-trapping layer for a semiconductor-on-insulator or piezoelectric-on-insulator structure for radiofrequency applications, comprising:
• placing a base substrate (10) comprising a layer (20) of native silicon oxide in a deposition chamber,
• raising the temperature of the deposition chamber up to a temperature (Tp) for depositing the charge-trapping layer (30),
• introducing an oxidizing gas into said deposition chamber in order to preserve the layer (20) of native silicon oxide during the temperature rise,
• removing the oxygen from the deposition chamber at the temperature (Tp) for forming the charge-trapping layer (30),
• depositing, in the deposition chamber, the charge-trapping layer (30) made of polycrystalline silicon on the layer (20) of native silicon oxide.

2. Method according to claim 1, further comprising forming a second layer (22) of silicon oxide between the first layer of native silicon oxide (20) and the base substrate (10).

3. Method according to claim 1 or claim 2, wherein the total thickness of the silicon oxide layer or layers (20, 22) is between 0.5 and 1.5 nm.

4. Method according to any one of the preceding claims, wherein the time elapsed between the end of the removal of oxygen and the beginning of the deposition of the charge-trapping layer is greater than 30 seconds.

5. Method according to any one of the preceding claims, wherein the deposition temperature of the charge-trapping layer is greater than 950°C.

6. Method according to any one of the preceding claims, wherein the oxidizing gas comprises oxygen or a mixture of argon and oxygen.

7. Method according to any one of the preceding claims, wherein the base substrate is made of monocrystalline silicon.

8. Method according to any one of the preceding claims, wherein the charge-trapping layer is made of polycrystalline silicon.

9. Method according to any one of the preceding claims, wherein the formation of the charge-trapping layer is carried out by a chemical vapor deposition (CVD) process.

10. Method for manufacturing a semiconductor-on-insulator or piezoelectric-on-insulator structure for radiofrequency applications, **characterized in that** it comprises the following steps:
• manufacturing a support substrate (100) by a method according to any one of the preceding claims,
• providing a donor substrate (50) that is semiconductor or piezoelectric,
• forming an electrically insulating layer (40) on the charge-trapping layer (30) and/or on said donor substrate (50),
• bonding the donor substrate (50) onto the support substrate via the electrically insulating layer,
• transferring the semiconductor or piezoelectric layer (55) onto the support substrate (100), the electrically insulating layer (40) being arranged at the interface between the transferred semiconductor or piezoelectric layer (55) and the charge-trapping layer (30).

11. Method according to claim 10, further comprising a step of forming a weakening zone (51) in the donor substrate (50) so as to delimit a semiconductor or piezoelectric layer (55) to be transferred, and wherein the transfer of the semiconductor or piezoelectric layer (55) onto the support substrate comprises detaching the donor substrate (50) along said weakening zone (51).

12. Method according to claim 11, comprising, before the step of forming the weakening zone in the donor substrate, a step of bonding said donor substrate (50) onto a temporary substrate (52) so as to form a so-called pseudo-donor substrate (53), and wherein the bonding step comprises bonding said pseudo-donor substrate (53) onto the support substrate (100) via the electrically insulating layer (40).

13. Method according to claim 10, wherein the transfer of the semiconductor or piezoelectric layer (55) onto the support substrate comprises thinning the donor substrate from the side opposite the electrically insulating layer.

14. Method according to any one of claims 10 to 13, wherein the donor substrate is semiconductor and comprises silicon.

15. Method according to any one of claims 10 to 13, wherein the donor substrate is piezoelectric and comprises a compound of formula ABO₃, where A is selected from barium and lithium and B is selected from tantalum, titanium and niobium.
